# EUROPEAN PATENT APPLICATION

(11) **EP 1 811 548 A1**
(43) Date of publication of application: **25.07.2007**
(21) Application number: 05793216.2
(22) Date of filing: 14.10.2005
(51) Int. Cl.: H01L 21/20, H01L 21/02, H01L 27/12

(54) **SEMICONDUCTOR WAFER MANUFACTURING METHOD**

(30) Priority: 20.10.2004 JP 2004305637
(71) Applicant: SHIN-ETSU HANDOTAI COMPANY LIMITED, Chiyoda-ku Tokyo 100-0005 (JP)
(72) Inventor: YOKOKAWA, Isao, c/o Yokonodaira Plant, Nakanoya, Annaka-shi, Gunma 379-0125 (JP); NOTO, Nobuhiko, c/o Yokonodaira Plant, Nakanoya, Annaka-shi, Gunma 379-0125 (JP)
(74) Representative: Wibbelmann, Jobst
(86) International application number: PCT/JP2005/018929
(87) International publication number: WO 2006/043471

(57) **Abstract**

The present invention is a method for producing a semiconductor wafer, comprising at least steps of:
epitaxially growing a SiGe layer on a surface of a silicon single crystal wafer that is to be a bond wafer;
implanting at least one kind of hydrogen ion and rare gas ion through the SiGe layer, so that an ion implanted layer is formed inside the bond wafer;
closely contacting and bonding a surface of the SiGe layer and a surface of a base wafer through an insulator film; then
performing delamination at the ion implanted layer,
removing a Si layer in a delaminated layer transferred to a side of the base wafer by the delamination, so that the SiGe layer is exposed; and then
subjecting the exposed SiGe layer to a heat treatment for enriching Ge under an oxidizing atmosphere and/or a heat treatment for relaxing lattice strain under a non-oxidizing atmosphere. Thereby, a method for producing a semiconductor wafer having a SiGe layer in which lattice relaxation is sufficiently performed and of which surface roughness is suppressed and of which crystallinity is good is provided.

## Description

### Technical Field

The present invention relates to a method for producing a semiconductor wafer having a SiGe layer on an insulator.

### Background Art

In recent years, in order to meet demands for high-speed semiconductor devices, there has been proposed semiconductor devices, such as a high-speed MOSFET (Metal-Oxide-Semiconductor Field Effect Transistor) in which a Si layer that is epitaxially grown on a Si (silicon) substrate through a SiGe (Silicon Germanium) layer is used in a channel region.

In this case, because SiGe crystal has a larger lattice constant than that of Si crystal, tensile strain is being generated in the Si layer that is epitaxially grown on the SiGe layer (hereinafter, such a Si layer in which strain is being generated is called as a strained Si layer). By its strain stress, an energy band structure of the Si crystal is changed and therefore degeneracy of the energy band is dissolved and an energy band with high carrier-mobility is formed. Therefore, MOSFET, in which the strained Si layer is used as the channel region, indicates a higher-speed operating characteristic at approximately 1.3 to 8 times than that of a general MOSFET.

As a method for forming such a strained Si layer, there is a method for using an SOI (Silicon On Insulator) wafer in which on a silicon support layer, an insulator layer such as a BOX (Buried OXide) layer is formed and thereon a silicon active layer (SOI layer) is formed. In the method, the SiGe layer is epitaxially grown on the SOI wafer, and then an oxide film is formed on a surface of the SiGe layer by an oxidation heat treatment, and thereby the SiGe layer is enriched (oxidized and enriched) to have a desired Ge concentration, and thereon the Si layer is epitaxially grown to be a strained Si layer (see, for example, N. Sugiyama et al., Extended Abstracts of the 2002 International Conference on Solid State Devices and Materials, Nagoya, 2002, pp. 146-147, and T. Tezuka et al., Appl. Phys. Lett., Vol. 79, No. 12, pp. 1798-1800, 17 September 2001). In this case, for forming a strained Si layer having sufficient strain on the SiGe layer, the SiGe layer is required to be sufficiently lattice-relaxed so as to have an lattice constant that is near an intrinsic lattice constant determined by its Ge concentration. Moreover, there has been disclosed a method for oxidizing and enriching a wafer in which on the SOI wafer, a SiGe crystal layer is formed and further a Si crystal layer is formed (see, Japanese Patent Application (Kokai) No. 2000-243946). A wafer in which the SiGe layer is formed on the insulator film as described above is occasionally described as an SGOI (SiGe On Insulator) wafer.

On the other hand, as well as such a method in which an epitaxial method is main as described above, there has been disclosed a method for forming a SiGe layer on a silicon single crystal wafer to be a bond wafer, then forming an oxide film on a surface of the SiGe layer by an oxidation heat treatment and thereby performing oxidation and enrichment, bonding therewith a base wafer made of silicon single crystal through an oxide film, thereby producing a bonded SOI wafer having an SOI structure, and then thinning the bond wafer so that the bond wafer becomes a strained Si layer (see, Japanese Patent Application Laid-open (kokai) No. 2002-164520). In this case, the thinning of the bond wafer is performed with an ion implantation delamination method (which is also referred to as a smart cut (a registered trademark) method), or the like. The ion implantation delamination method is a method of implanting hydrogen ion or rare gas ion from a surface of the wafer and thereby forming an ion implanted layer, then delaminating the wafer in a thin-film form by a subsequent heat treatment so that the ion implanted layer is a cleavage plane (a delaminating plane).

However, in the SiGe layer in the SGOI wafer produced by such a conventional method as described above, occasionally, a large number of streak-like irregularities called as crosshatch are generated on the oxidized and enriched surface and surface roughness is caused and also threading dislocations or the like are generated and its crystallinity becomes degraded.

### Disclosure of the Invention

An object of the present invention is to provide a method for producing a semiconductor wafer having a SiGe layer in which lattice relaxation is sufficiently performed and of which surface roughness is suppressed and of which crystallinity is good.

To achieve the above object, the present invention provides a method for producing a semiconductor wafer, comprising at least steps of:
epitaxially growing a SiGe layer on a surface of a silicon single crystal wafer that is to be a bond wafer;
implanting at least one kind of hydrogen ion and rare gas ion through the SiGe layer, so that an ion implanted layer is formed inside the bond wafer;
closely contacting and bonding a surface of the SiGe layer and a surface of a base wafer through an insulator film; then
performing delamination at the ion implanted layer;
removing a Si layer in a delaminated layer transferred to a side of the base wafer by the delamination, so that the SiGe layer is exposed; and then
subjecting the exposed SiGe layer to a heat treatment for enriching Ge under an oxidizing atmosphere and/or a heat treatment for relaxing lattice strain under a non-oxidizing atmosphere.

When a SiGe layer is epitaxially grown on a surface of a bond wafer and then an ion implanted layer is formed inside the bond wafer and the bond wafer is bonded to a base wafer and then delamination is performed as described above, a delaminated layer transferred to a side of the base wafer hereby comes to comprise the Si layer and the SiGe layer. Therefore, because a thickness of the delaminated layer can be thicker than that of the case in which only the SiGe layer is transferred, failure in the delamination becomes difficult to be caused, and even when a heat treatment is performed at a high temperature thereafter, generation of voids or blisters is suppressed. And, when the Si layer in the delaminated layer is removed and then a heat treatment for enriching Ge in the SiGe layer and/or a heat treatment for relaxing lattice strain are/is performed, an interface of crystals having different lattice constants between the Si layer and the SiGe layer comes not to exist in the heat treatment. Thereby, because misfit dislocations are not introduced in the SiGe layer even when lattice relaxation occurs in the heat treatment, generation of threading dislocations can be suppressed, and surface roughness due to generation of crosshatch can be suppressed. And, because a surface of the SiGe layer and a surface of the base wafer are closely contacted and bonded through an insulator film such as silicon oxide film, slip deformation at an interface between the SiGe layer and the base wafer becomes easy to occur. In addition, the interface is not an interface of crystal, and therefore, in the SiGe layer, generation of misfit dislocations or the like is suppressed and therewith lattice relaxation is sufficiently performed.

In addition, hereinafter, the heat treatment for enriching Ge in the SiGe layer under an oxidizing atmosphere is occasionally referred to as heat treatment for oxidation and enrichment, and the heat treatment for lattice-relaxing the SiGe layer under a non-oxidizing atmosphere is occasionally referred to as heat treatment for relaxing lattice. In addition, as the non-oxidizing gas, argon, nitrogen, hydrogen, mixed gas thereof, or the like, can be used.

Moreover, the present invention provides a method for producing a semiconductor wafer, comprising at least steps of:
epitaxially growing a plurality of SiGe layers through a Si layer, on a surface of a silicon single crystal wafer that is to be a bond wafer;
implanting at least one kind of hydrogen ion and rare gas ion through the plurality of SiGe layers, so that an ion implanted layer is formed inside the bond wafer;
closely contacting and bonding a surface of the SiGe layer that is an uppermost layer of the plurality of SiGe layers and a surface of a base wafer, through an insulator film; then
performing delamination at the ion implanted layer;
removing the Si layer and the SiGe layer, in a delaminated layer transferred to a side of the base wafer by the delamination, so that the SiGe layer that is the uppermost layer is exposed; and then
subjecting the exposed SiGe layer to a heat treatment for enriching Ge by thermal oxidation under an oxidizing atmosphere and/or a heat treatment for relaxing lattice strain under a non-oxidizing atmosphere.

When a layer that is epitaxially grown on a surface of a bond wafer is a plurality of SiGe layers through a Si layer as described above, a delaminated layer being transferred comes to comprise a plurality of Si layers and SiGe layers. Therefore, because a thickness of the delaminated layer can be thicker, even when a heat treatment is performed at a high temperature thereafter, generation of voids or blisters is suppressed. And, when a heat treatment for enriching Ge and/or a heat treatment for relaxing lattice strain are/is performed in a SiGe layer that is the uppermost layer which is exposed by removing the Si layers and the SiGe layers in the delaminated layer, an interface of crystals having different lattice constants between the Si layer and the SiGe layer does not exist in the heat treatment, and misfit dislocations are not introduced in the SiGe layer even when lattice relaxation occurs. Therefore, generation of threading dislocations can be suppressed, and surface roughness due to generation of crosshatch can be suppressed. Moreover, because the delaminated layer being transferred comprises the plurality of Si layers and SiGe layers, when the delaminated layer is removed, a plurality of removal steps can be combined and performed, and thereby the exposed surface of the SiGe layer can be smoother. And, because a surface of the SiGe layer that is the uppermost layer and a surface of the base wafer are closely contacted and bonded through an insulator film such as silicon oxide film, slip deformation at an interface between the SiGe layer and the base wafer becomes easy to occur. In addition, the interface is not an interface of crystal, and therefore, in the SiGe layer, generation of the misfit dislocations or the like is suppressed and therewith lattice relaxation is sufficiently performed.

In this case, it is preferable that after performing the heat treatment for enriching Ge and/or the heat treatment for relaxing lattice strain, a Si single crystal layer is epitaxially grown on a surface of the exposed SiGe layer.

As described above, according to the present invention, even after the heat treatment for oxidation and enrichment and/or the heat treatment for relaxing lattice are/is performed, in the exposed SiGe layer, generation of threading dislocations is suppressed and also surface roughness is suppressed. Therefore, if a Si single crystal layer is epitaxially grown on the exposed surface of the SiGe layer, a strained Si layer of good quality having sufficient strain can be obtained.

Moreover, it is preferable that after the delamination at the ion implanted layer, a heat treatment for enhancing strength of the bonding at a temperature of 800°C or less under a non-oxidizing atmosphere is performed.

When a heat treatment for enhancing strength of the bonding at a temperature of 800°C or less under a non-oxidizing atmosphere is performed as described above, misfit dislocations are not generated and the bonding strength can be enhanced. Therefore, generation of voids or blisters due to bonding failure can be prevented.

Moreover, it is possible that the removal of the Si layer and/or the SiGe layer is performed by at least any one of, polishing, etching, and removal of an oxide film after thermal oxidation at a temperature of 800°C or less under an oxidizing atmosphere.

When the removal of the Si layer and/or the SiGe layer is performed by polishing, etching, or removal of an oxide film after thermal oxidation at a temperature of 800°C or less under an oxidizing atmosphere as described above, the exposed surface of the SiGe layer can be so smooth that a strained Si layer of good quality can be epitaxially grown. And, if the removal steps by these different methods are appropriately combined, the exposed surface of the SiGe layer can be smoother.

Moreover, it is preferable that before performing the heat treatment for enriching Ge and/or the heat treatment for relaxing lattice strain, an oxide film is formed on a surface of the exposed SiGe layer.

When an oxide film is formed on a surface of the exposed SiGe layer before performing the heat treatment for oxidation and enrichment and/or the heat treatment for relaxing lattice as described above, Ge in the SiGe layer can be prevented from out-diffusing in the heat treatment.

Moreover, it is preferable that a Ge composition in the SiGe layer is 20% or less.

When a Ge composition in the SiGe layer is 20% or less, the SiGe layer can have sufficiently few dislocations.

Moreover, it is preferable that the insulator film through which the surface of the SiGe layer and the surface of the base wafer are closely contacted is formed on the surface of the base wafer.

When the surfaces of the base wafer and the SiGe layer are closely contacted and bonded through an insulator film formed on the surface of the base wafer as described above, slip deformation at the bonded surface between the SiGe layer and the base wafer become sufficiently easy to occur, and additionally, the interface is not an interface of crystal, and therefore, in the SiGe layer that is thereafter subjected to the heat treatment for oxidation and enrichment and/or the heat treatment for relaxing lattice, generation of misfit dislocations is suppressed and lattice relaxation is sufficiently performed.

Moreover, it is preferable that the insulator film through which the surface of the SiGe layer and the surface of the base wafer are closely contacted is formed at least on the surface of the SiGe layer at a thickness of 50 nm or less.

When the insulator film through which the surface of the SiGe layer and the surface of the base wafer are closely contacted is formed at least on the surface of the SiGe layer at a thickness of 50 nm or less as described above, slip deformation to occur at the bonded surface becomes sufficient, and in the SiGe layer that is thereafter subjected to the heat treatment for oxidation and enrichment and/or the heat treatment for relaxing lattice, generation of misfit dislocations is suppressed and therewith lattice relaxation is sufficiently performed.

Moreover, it is possible that as the base wafer, a silicon single crystal wafer or an insulator wafer is used.

When the base wafer is a silicon single crystal wafer, an insulator film can be easily formed by thermal oxidation, a vapor growth method, or the like, and the surface of the SiGe layer can be closely contacted through the insulator film. Moreover, according to use, the base wafer of insulator such as quartz, silicon carbide, alumina, or diamond may be used.

Moreover, it is preferable that a temperature in the heat treatment for enriching Ge is 900°C or more.

When a temperature in the heat treatment for oxidation and enrichment to which the SiGe layer is subjected is 900°C or more, the diffusion velocity of Ge becomes sufficiently high, and the Ge can be prevented from accumulating and being precipitated in the interface between the oxide film and the SiGe layer.

According to the present invention, when a SiGe layer is epitaxially grown on the surface of a bond wafer and then the ion implanted layer is formed inside the bond wafer and then the bond wafer and a base wafer are bonded and then delamination is performed, an thickness of a delaminated layer being transferred can be thicker, and therefore, failure in the delamination becomes difficult to occur, and even when the wafer is thereafter heat-treated at a high temperature, generation of voids and blisters can be suppressed. And, when the Si layer in the delaminated layer is removed and then a heat treatment for enriching Ge in the SiGe layer and/or a heat treatment for relaxing lattice strain are/is performed, misfit dislocations are not introduced in the SiGe layer even when lattice relaxation occurs in the heat treatment, and therefore, generation of threading dislocations can be suppressed, and surface roughness due to generation of crosshatch can be suppressed. And, because a surface of the SiGe layer and a surface of the base wafer are closely contacted and bonded through an insulator film such as silicon oxide film, slip deformation at an interface between the SiGe layer and the base wafer becomes easy to occur. In addition, the interface is not an interface of crystal, and therefore, in the SiGe layer, generation of the misfit dislocations or the like is suppressed and lattice relaxation is sufficiently performed.

Accordingly, a strained Si layer of good quality having sufficient strain can be epitaxially grown on the surface.

### Brief Explanation of the Drawings

Fig. 1 is a view showing an example of a process for producing a semiconductor wafer according to a first embodiment of the present invention.
Fig. 2 is a view showing an example of a process for producing a semiconductor wafer according to a second embodiment of the present invention.

### Best Mode for Carrying out the Invention

Hereinafter; the present invention will be explained in detail. As described above, in a SiGe layer in an SGOI wafer produced by a conventional method, occasionally, a large number of crosshatches are generated on a surface of the wafer after performing oxidation and enrichment and surface roughness is caused and also threading dislocations or the like are generated and its crystallinity becomes degraded. If a Si layer is epitaxially grown on such a SiGe layer, the Si layer has only become a strained Si layer of low crystallinity.

The present inventors have thought that such generation of crosshatches or threading dislocations are caused by the reason that there is a crystalline interface between the SiGe layer and the Si layer having different lattice constants in a conventional SGOI wafer and thereby misfit dislocations are generated along with lattice relaxation at the crystalline interface in a heat treatment for oxidation and enrichment or a heat treatment for relaxing lattice and introduced in the SiGe layer. When a device is fabricated on a strained Si layer formed on the SiGe layer, the threading dislocation formed by introducing the misfit dislocation in the SiGe layer as described above becomes a leakage pathway for electric currents and triggers inhibition of operation of the device. Moreover, by the introduction of misfit dislocations, the crosshatch is generated and surface roughness is caused and crystallinity of the strained Si layer to be formed thereon becomes low.

Then, for solving such problems, the present inventors have found that the crystalline interface is made not to exist in a heat treatment at a high temperature of 800°C or more, such as oxidation and enrichment in which lattice relaxation occurs. And, when the SGOI wafer is produced, the SiGe layer is epitaxially grown on a surface of a bond wafer of silicon single crystal, and an ion implanted layer is formed inside the bond wafer, and the surface of the SiGe layer and a surface of a base wafer are closely contacted and bonded through an insulator film, and then delamination is performed at the ion implanted layer, and before the heat treatment for oxidation and enrichment or the heat treatment for relaxing lattice, the delaminated Si layer is removed. Thereby, the crystalline interface between the SiGe layer and the Si layer comes not to exist in the heat treatment. Therefore, even when a heat treatment at a high temperature such as the heat treatment for oxidation and enrichment is performed in the state, misfit dislocations due to the interface of crystal come not to be generated. Accordingly, surface roughness is suppressed and density of threading dislocations can be reduced and an ideal SiGe crystal can be formed.

The present inventors have found the above things and accomplished the present invention.

Hereinafter, embodiments according to the present invention will be explained with reference to drawings. However, the present invention is not limited thereto.

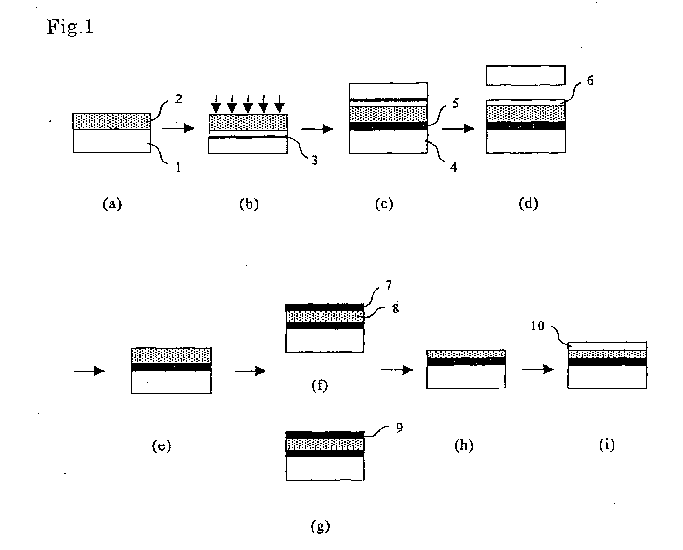

Fig. 1(a)-(i) is a view showing an example of a process for producing a semiconductor wafer according to a first embodiment of the present invention.

First, as shown in Fig. 1(a), by a vapor growth method, a SiGe layer 2 is epitaxially grown at a thickness of approximately 10-500 nm on a surface of a silicon single crystal wafer 1 to be a bond wafer. In this time, by the difference between the SiGe layer and the Si single crystal in lattice constant, lattice strain (compression strain) is generated in the SiGe layer 2. In this case, a Ge composition in the SiGe layer 2 can be constant. On the other hand, the SiGe layer can be formed as a layer whose Ge composition is not constant, such as a gradient composition layer whose Ge composition is 0% at an initiation of the growth and is gradually increased toward its surface. In addition, when the Ge composition is 20% or less or preferably 15% or less, dislocation can be sufficiently suppressed.

The vapor growth can be performed by a CVD (Chemical Vapor Deposition) method, an MBE (Molecular Beam Epitaxy) method, or the like. In the case of the CVD method, for example, as the material gas, a mixed gas of SiH₄ or SiH₂Cl₂ and GeH₄ can be used. As the carrier gas, H₂ can be used. As the growth condition, for example, temperature may be 400-1000°C and the pressure may be 100 Torr (1.33×10⁴ Pa) or less.

Next, as shown in Fig. 1(b), an ion implanted layer 3 is formed inside the silicon single crystal wafer 1 by implanting at least one kind of hydrogen ion and rare gas ion through the SiGe layer 2 by a predetermined dose amount. In this case, because depth of the ion implantation depends on magnitude of energy of the implantation, the implantation energy may be set for a desired depth of the implantation.

Next, as shown in Fig. 1(c), a surface of the SiGe layer 2 and a surface of a base wafer 4 are closely contacted and bonded through a silicon oxide film 5 that is an insulator film at room temperature. As the base wafer 4, silicon single crystal wafer, an insulator wafer such as quartz, silicon carbide, alumina, or diamond can be used. In this case, before performing the bonding at room temperature, generally, the surfaces to be bonded are required to be sufficiently cleaned. For example, in the case of performing the cleaning with a mixed aqueous solution of NH₄OH and H₂O₂ (SC-1: Standard Cleaning 1), it is preferable that the cleaning condition is selected so that surface roughness on the surface of the SiGe layer which is easier to cause the surface roughness by an etching action during the cleaning than that of Si is suppressed to the minimum. In this case, the silicon oxide film 5 can be formed either on the surface of the SiGe layer 2 or on the surface of the base wafer 4, or both. In the case of forming the silicon oxide film only on the surface of the base wafer 4, an interface between the SiGe layer 2 and the silicon oxide film 5 becomes the bonded surface, and therefore, at the bonded surface, slip deformation is easy to occur and lattice relaxation is easy to be performed when the SiGe layer 2 is subjected to an heat treatment for oxidation and enrichment and/or a heat treatment for relaxing lattice in a subsequent step. Therefore, generation of misfit dislocations can be effectively suppressed. Moreover, in the case of forming the silicon oxide film 5 on the surface of the SiGe layer 2, if its thickness is 50 nm or less, slip deformation occurring at the bonded surface becomes sufficient, and in the SiGe layer 2 that is thereafter subjected to a heat treatment, generation of misfit dislocations is suppressed and therewith lattice relaxation is sufficiently performed.

Next, as shown in Fig. 1(d), delamination is performed by, for example, a heat treatment at approximately 500°C (delamination heat treatment) so that the ion implanted layer 3 serves as a cleavage plane. Thereby, the SiGe layer 2 and a part 6 of the silicon single crystal wafer 1 are transferred to a side of the base wafer as a delaminated layer. In the present invention because the ion implanted layer 3 is formed inside the silicon single crystal wafer 1, the entirety of the epitaxially grown SiGe layer 2 can be transferred to the side of the base wafer and utilized. Moreover, because the Si layer 6 is also transferred as well as the SiGe layer 2, a thickness of the delaminated layer can be thicker than that of the case of transferring only the SiGe layer 2. Thereby, failure in the delamination becomes difficult to be caused and generation of voids or blisters is suppressed even when the wafer is thereafter heat-treated at a high temperature.

In addition, as a pretreatment for the step of closely contacting the surface of the SiGe layer 2 and the surface of the base wafer 4 as shown in Fig. 1(c), strength of the close contact is enhanced by plasma-treating the surfaces to be closely contacted of the both wafers, and thereby the delamination can also be mechanically performed at the ion implanted layer 3 without performing the delamination heat treatment after the close contact.

Moreover, after the delamination step at the ion implanted layer 3 as shown in Fig. 1(d), if a heat treatment for enhancing the bonding strength at a temperature of 800°C or less under a non-oxidizing atmosphere, the bonding strength can be enhanced without generating misfit dislocations, and therefore, threading dislocations or surface roughness can be prevented from being generated in the SiGe layer, and generation of voids or blisters due to failure of the bonding can be prevented.

Next, as shown in Fig. 1(e), the Si layer 6 transferred to the side of the base wafer is removed.

It is preferable that the removal is performed by at least any one of polishing, etching, removal of an oxide film after thermal oxidation at a temperature of 800°C or less under an oxidizing atmosphere because the exposed surface of the SiGe layer can be so smooth that a strained Si layer of good quality can be epitaxially grown. In particular, the polishing is preferable because the Si layer 6 can be removed along with improving the surface roughness generated in the delamination which remains in a surface of the Si layer 6. In the polishing, for example, a conventional CMP can be used. Moreover, in the case of the etching, TMAH (tetramethylammonium hydroxide) can be used as the etching solution. According to a TMAH solution, when the Si layer is removed and the TMAH solution reaches the SiGe layer, the etching stops, namely, etch stop occurs, by selectivity of the TMAH solution. The surface of the SiGe layer to be exposed by such an etch stop method is preferable because the surface becomes smooth. Moreover, the thermal oxidation at a temperature of 800°C or less and the subsequent removal of the oxide film are preferable because the heat treatment is at a low temperature and therefore misfit dislocations are not generated. The thermal oxidation can be performed under an oxidizing atmosphere, for example, under an atmosphere of 100% wet oxygen. Moreover, the removal of the oxide film can be performed by, for example, immersing the wafer in a 15% HF aqueous solution. Then, if the removal steps according to the different methods are approximately combined, the exposed surface of the SiGe layer can be smoother.

Next, the exposed SiGe layer 2 is subjected to a heat treatment for oxidation and enrichment in order to enrich Ge under an oxidizing atmosphere and/or a heat treatment for relaxing lattice in order to relax the lattice strain under a non-oxidizing atmosphere.

In the case of performing the heat treatment for oxidation and enrichment, as shown in Fig. 1(f), the surface of the SiGe layer 2 is thermally oxidized, for example, under a dry oxygen atmosphere, and thereby a thermal oxide film 7 is formed. When a part of the SiGe layer 2 is thermally oxidized, Ge existing in the thermally oxidized part is transferred to a part that is not thermally oxidized because Ge is hardly taken in the oxide film. Therefore, an enriched SiGe layer 8 in which Ge is enriched is formed. By oxidizing the SiGe layer 2 as described above, the Ge composition in the enriched SiGe layer 8 is enhanced, and therefore, stronger lattice strain (compression strain) occurs in the enriched SiGe layer 8. However, in the present invention, in the heat treatment for oxidation and enrichment, the Si layer 6 is already removed and the enriched SiGe layer 8 is being sandwiched between the oxide films 5, 7, and therefore, slip deformation occurs at the amorphous interface so that the strain of the enriched SiGe layer 8 is relaxed, and generation of misfit dislocations in the enriched SiGe layer 8 is suppressed and therewith lattice relaxation is achieved. Accordingly, surface roughness is suppressed and density of threading dislocations is reduced and an ideal SiGe layer can be formed. In addition, such a threading dislocation can be confirmed as a Secco defect by subjecting the bonded wafer to Secco-etching.

In addition, because diffusion velocity of Ge is slow if the temperature for thermal oxidation at this time is less than 900°C, the Ge becomes easy to accumulate in the interface between the thermal oxide film 7 and the enriched SiGe layer 8 and to cause precipitation. Therefore, it is desirable that the thermal oxidation temperature is set to 900°C or more, or preferably 1000°C or more. Moreover, by adding to perform the heat treatment under a non-oxidizing atmosphere after the oxidation, the Ge can be made to diffuse and the Ge concentration can be uniform in the depth direction. Moreover, it is preferable that the heat treatment for oxidation and enrichment is performed after a damaged layer in the surface of the SiGe layer 2 is slightly polished (touch-polished).

On the other hand, in the case of performing the heat treatment for relaxing lattice, as shown in Fig. 1(g), first, it is preferable that an oxide film 9 is formed on the surface of the SiGe layer 2. Thereby, in the heat treatment for relaxing lattice, the Ge of the SiGe layer 2 can be prevented from out-diffusing from the surface. The oxide film 9 can be formed by a CVD method, for example, at a temperature of approximately 400°C. Moreover, the oxide film may be formed by thermal oxidation under an atmosphere of 100% wet oxygen at a temperature of approximately 800°C.

Next, the heat treatment for relaxing lattice is performed under a non-oxidizing atmosphere such as argon, for example, at a temperature of approximately 1200°C. In the present invention, in the heat treatment for relaxing lattice, the Si layer 6 is already removed and the SiGe layer 2 is being sandwiched between the oxide films 5, 9, and therefore, slip deformation occurs at the amorphous interface so that the strain of the enriched SiGe layer 2 is relaxed, and generation of misfit dislocations in the enriched SiGe layer 2 is suppressed and therewith lattice relaxation is achieved. Accordingly, surface roughness is suppressed and density of threading dislocations is reduced and an ideal SiGe layer can be formed.

In addition, any one of the heat treatment for oxidation and enrichment and the heat treatment for relaxing lattice may be performed. However, both of them may be performed for obtaining the desired Ge composition and the lattice relaxation. The extent of the lattice relaxation can be evaluated by calculating lattice relaxation rate by using an X-ray diffraction method.

Next, as shown in Fig. 1(h), the oxide film 7 or 9 formed on the surface of the SiGe layer subjected to the heat treatment for oxidation and enrichment and/or the heat treatment for relaxing lattice is removed, and thereby the SiGe layer 2 or the enriched SiGe layer 8 is exposed. The removal of the oxide film can be performed by, for example, immersing the wafer in a 15% HF aqueous solution.

Last, as shown in Fig. 1(i), a Si single crystal layer 10 is epitaxially grown on the exposed surface of the SiGe layer 2 or the enriched SiGe layer 8 by a vapor growth method. The epitaxial growth can be performed by a CVD method, an MBE method, or the like. In the case of the CVD method, for example, as the material gas, SiH₄ or SiH₂Cl₂ can be used. As the growth condition, temperature may be 400-1000°C and the pressure may be 100 Torr (1.33×10⁴ Pa) or less.

The Si single crystal layer 10 formed as described above becomes a strained Si layer having tensile strain therein, due to the difference in lattice constant between the Si single crystal layer and the SiGe layer 2 or the enriched SiGe layer 8, which is a lower layer. The Si single crystal layer becomes a strained Si layer of good quality having sufficient strain because the layer is formed on the SiGe layer of good quality in which density of threading dislocations is small and of which surface roughness is suppressed and which is sufficiently lattice-relaxed. It is preferable that a thickness of the epitaxially grown silicon single crystal layer 10 is approximately 10-50 nm, in order to ensure effective strain and workability in fabricating a device therein and quality.

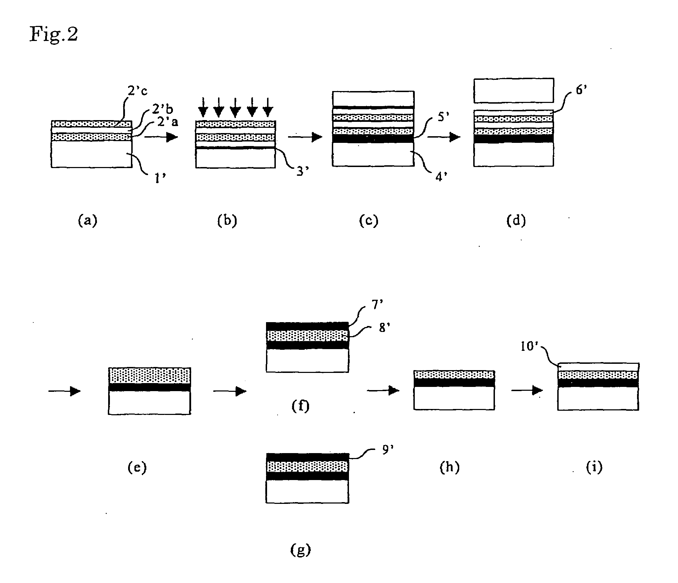

Fig. 2(a)-(i) is a view showing an example of a process for producing a semiconductor wafer according to a second embodiment of the present invention.

First, as shown in Fig. 2(a), by a vapor growth method, a SiGe layer 2'a, a Si layer 2'b, and a SiGe layer 2'c are epitaxially grown at a thickness of approximately 10-500 nm in order, on a surface of a silicon single crystal wafer 1' to be a bond wafer. A Ge composition, a thickness, or growth method, of the SiGe layer to be epitaxially grown as described above can be the same as the above-described Fig. 1(a). Moreover, the Si layer 2'b can have, for example, a thickness of 50 nm. However, the thickness, a growth method, and so forth, are not particularly limited.

Next, as shown in Fig. 2(b), an ion implanted layer 3' is formed inside the silicon single crystal wafer 1' by implanting at least one kind of hydrogen ion and rare gas ion through the SiGe layer 2'a, the Si layer 2'b, and the SiGe layer 2'c by a predetermined dose amount. As described above, because depth of the ion implantation depends on magnitude of energy of the implantation, the implantation energy may be set for a desired depth of the implantation.

Next, as shown in Fig. 2(c), a surface of the SiGe layer 2'c that is an uppermost layer and a surface of a base wafer 4' are closely contacted and bonded through a silicon oxide film 5' that is an insulator film. As described above, in the case of performing the cleaning by SC-1, it is preferable that the cleaning condition is selected so that surface roughness on the surface of the SiGe layer is suppressed to the minimum. Also, in this case, the silicon oxide film 5' can be formed either on the surface of the SiGe layer 2'c or on the surface of the base wafer 4', or both. In the case of forming the silicon oxide film only on the surface of the base wafer 4', lattice relaxation is easy to be performed in the heat treatment of a subsequent step. Therefore, generation of misfit dislocations in the SiGe layer 2'c can be effectively suppressed. Moreover, in the case of forming the silicon oxide film 5' on the surface of the SiGe layer 2'c, if its thickness is 50 nm or less, generation of misfit dislocations is suppressed and therewith lattice relaxation is sufficiently performed, in the SiGe layer 2'c that is thereafter subjected to a heat treatment.

Next, as shown in Fig. 2(d), delamination is performed by, for example, a heat treatment at approximately 500°C (delamination heat treatment) so that the ion implanted layer 3' serves as a cleavage plane. Thereby, the SiGe layer 2'a, the Si layer 2'b, the SiGe layer 2'c, and a part 6' of the silicon single crystal wafer 1' are transferred to a side of the base wafer as a delaminated layer. In the present invention, because the Si layer 6' is also transferred as well as the SiGe layer 2'a, the Si layer 2'b, and the SiGe layer 2'c, a thickness of the delaminated layer can be thicker than that of the above-described case of Fig. 1(d). Thereby, failure in the delamination becomes more difficult to be caused and generation of voids or blisters is suppressed even when the wafer is thereafter heat-treated at a high temperature.

In addition, as a pretreatment for the step of closely contacting the surface of the SiGe layer 2'c and the surface of the base wafer 4' as shown in Fig. 2(c), strength of the close contact is enhanced by plasma-treating the surfaces to be closely contacted of the both wafers, and thereby the delamination can also be mechanically performed at the ion implanted layer 3' without performing the delamination heat treatment after the close contact. Moreover, after the delamination step at the ion implanted layer 3' as shown in Fig. 2(d), if a heat treatment for enhancing the bonding strength at a temperature of 800°C or less under a non-oxidizing atmosphere, the bonding strength can be enhanced without generating misfit dislocations, and therefore, threading dislocations or surface roughness can be prevented from being generated in the SiGe layer, and generation of voids or blisters due to failure of the bonding can be prevented.

Next, as shown in Fig. 2(e), the SiGe layer 2'a, the Si layer 2'b, and the Si layer 6' that are transferred to the side of the base wafer are removed, and thereby the SiGe layer 2'c is exposed.

It is preferable that the removal is performed by at least any one of polishing, etching, removal of an oxide film after thermal oxidation at a temperature of 800°C or less under an oxidizing atmosphere because the exposed surface of the SiGe layer can be so smooth that a strained Si layer of good quality can be epitaxially grown. In particular, the polishing is preferable because the Si layer 6' can be removed along with improving the surface roughness generated in the delamination which remains in a surface of the Si layer 6'. In the polishing, for example, a conventional CMP can be used. Moreover, in the case of the etching, in removing the Si layer, TMAH can be used as the etching solution, and in removing the SiGe layer, an aqueous solution of mixed acid of HF, HNO₃, and CH₃COOH can be used. According to the TMAH solution, when the Si layer is removed and the TMAH solution reaches the SiGe layer, the etch stop occurs by selectivity of the TMAH solution. According to the mixed acid, when the SiGe layer is removed and the mixed acid reaches the Si layer, the etch stop occurs. The surface of the SiGe layer exposed by repeating a plurality of the etch stops as described above is preferable because the surface becomes smoother. Moreover, the thermal oxidation at a temperature of 800°C or less and the subsequent removal of the oxide film are preferable because the heat treatment is at a low temperature and therefore misfit dislocations are not generated. The thermal oxidation can be performed under an oxidizing atmosphere, for example, under an atmosphere of 100% wet oxygen. Moreover, the removal of the oxide film can be performed by, for example, immersing the wafer in a 15% HF aqueous solution. Then, if the removal steps according to the different methods are approximately combined, the exposed surface of the SiGe layer can be smoother.

Next, as shown in Fig. 2(f) or (g), the exposed SiGe layer 2'c is subjected to a heat treatment for oxidation and enrichment in order to enrich Ge under an oxidizing atmosphere or a heat treatment for relaxing lattice in order to relax the lattice strain under a non-oxidizing atmosphere. These heat treatments can be performed in the same manner as Fig. 1(f) or (g).

Next, as shown in Fig. 2(h), the oxide film 7' or 9' formed on the surface of the SiGe layer subjected to the heat treatment for oxidation and enrichment and/or the heat treatment for relaxing lattice is removed, and thereby the SiGe layer 2'c or the enriched SiGe layer 8' is exposed. Last, as shown in Fig. 2(i), a Si single crystal layer 10' is epitaxially grown on the exposed surface of the SiGe layer 2'c or the enriched SiGe layer 8' by a vapor growth method. These steps can be performed in the same manner as Fig. 1(f)-(i).

The Si single crystal layer 10' formed as described above becomes a strained Si layer having tensile strain therein, due to the difference in lattice constant between the Si single crystal layer and the SiGe layer 2'c or the enriched SiGe layer 8', which is a lower layer. The Si single crystal layer becomes a strained Si layer of good quality having sufficient strain because the layer is formed on the SiGe layer of good quality in which density of threading dislocations is small and of which surface roughness is suppressed and which is sufficiently lattice-relaxed.

Hereinafter, the present invention will be specifically explained with reference to Examples of the present invention and Comparative example. However, the present invention is not limited thereto.

### (Example 1)

A SiGe layer (the Ge composition was 10%) was epitaxially grown only at approximately 120 nm by a CVD method, on a surface of a silicon single crystal wafer having a diameter of 200 mm, and through the SiGe layer, hydrogen ion (H⁺) was ion-implanted under the condition that the implantation energy was 20 keV and the dose amount was 5×10¹⁶ atoms/cm², and thereby an ion implanted layer was formed inside the silicon single crystal wafer. After the hydrogen ion implantation, the surface of the SiGe layer was cleaned with an SC-1 cleaning solution. This surface and a silicon single crystal base wafer with a thermal oxide film of 100 nm were closely contacted at a room temperature, and delamination heat treatment was performed under an argon atmosphere at 500°C for 30 min and thereby the delamination was performed at the ion implanted layer. Thereby, the SiGe layer and a part (Si layer) of the silicon single crystal wafer were transferred to a side of the base wafer. Next, the Si layer was oxidized under a wet oxygen atmosphere at a temperature of 800°C, and the wafer was immersed in a 15% HF aqueous solution and the oxide film was removed, and thereby, the Si layer transferred to the side of the base wafer was removed. In the SiGe layer exposed as described above, an enriched SiGe layer having a 20% Ge composition and a thickness of approximately 50 nm was formed by thermally oxidizing a part of the SiGe layer under an atmosphere of 100% dry oxygen at a temperature of 1200°C. Then, the thermal oxide film was removed by immersing the wafer in a 15% HF aqueous solution, and thereby the enriched SiGe layer was exposed. On its surface, a silicon layer was epitaxially grown only at a thickness of 15 nm by a CVD method.

Twenty semiconductor wafers produced as described above were prepared, and in their surfaces, a visual count of the number of generated voids and blisters was conducted, and the number of generated voids and blisters per one wafer was approximately one. Moreover, the surfaces were subjected to Secco-etching. And an observation of crystal defects was conducted. It was confirmed that there were few Secco defects and that generation of misfit dislocations was suppressed and also crosshatch did not exist. In addition, it was found that a lattice relaxation rate of the enriched SiGe layer before the silicon layer was epitaxially grown thereon was approximately 70% by an X-ray diffraction method and that the obtained value was near a theoretical value and sufficient.

### (Example 2)

A SiGe layer (the Ge composition was 20%) of approximately 100 nm, a Si layer of approximately 50 nm, and a SiGe layer (the Ge composition was 20%) of approximately 50 nm were epitaxially grown in order by a CVD method, on a surface of a silicon single crystal wafer having a diameter of 200 mm, and through these epitaxial layers, hydrogen ion (H⁺) was ion-implanted under the condition that the implantation energy was 20 keV and the dose amount was 5×10¹⁶ atoms/cm², and thereby an ion implanted layer was formed inside the silicon single crystal wafer. After the hydrogen ion implantation, the surface of the SiGe layer that is the uppermost layer was cleaned with an SC-1 cleaning solution. This surface and a silicon single crystal base wafer with a thermal oxide film of 100 nm were closely contacted at a room temperature, and delamination heat treatment was performed under an argon atmosphere at 500°C for 30 min and thereby the delamination was performed at the ion implanted layer. Thereby, the two SiGe layers, the Si layer between the SiGe layers, and a part (Si layer) of the silicon single crystal wafer were transferred to a side of the base wafer. Next, the wafer was immersed in a TMAH solution, and thereby a Si layer that was a part of the bond wafer was removed. Next, the wafer was immersed in the mixed acid of HF, HNO₃, and CH₃COOH, and thereby the SiGe layer of 100 nm was removed. Next, the Si layer between the SiGe layers was oxidized under a wet oxygen atmosphere at a temperature of 800°C, and the wafer was immersed in a 15% HF aqueous solution and the oxide film was removed, and thereby, the Si layer between the SiGe layers was removed. On a surface of the SiGe layer of a thickness of 50 nm exposed as described above, an oxide film of approximately 20 nm was formed by a CVD method. Then, a heat treatment for relaxing lattice in the exposed SiGe layer was performed under an argon atmosphere at a temperature of 1200°C. Then, the wafer was immersed in a 15% HF aqueous solution and thereby the oxide film was removed and thereby the SiGe layer was exposed. On its surface, a silicon layer was epitaxially grown only at a thickness of 15 nm.

Twenty semiconductor wafers produced as described above were prepared, and in their surfaces, a visual count of the number of generated voids and blisters was conducted, and the number of generated voids and blisters per one wafer was approximately one. Moreover, the surfaces were subjected to Secco-etching. And, an observation of crystal defects was conducted. It was confirmed that there were few Secco defects and that generation of misfit dislocations was suppressed and also crosshatch did not exist. In addition, it was found that a lattice relaxation rate of the enriched SiGe layer before the silicon layer was epitaxially grown thereon was approximately 65% by an X-ray diffraction method and that the obtained value was near a theoretical value and sufficient.

### (Comparative example)

By the same method as Example 1, a SiGe layer (the Ge composition was 10%) was epitaxially grown only at approximately 120 nm, on a surface of a silicon single crystal wafer having a diameter of 200 mm. In the SiGe layer, an enriched SiGe layer having a 20% Ge composition and a thickness of approximately 50 nm was formed by thermally oxidizing a part of the SiGe layer under an atmosphere of 100% dry oxygen at a temperature of 1200°C. At this stage, crosshatch was already observed on the enriched SiGe layer. Next, hydrogen ion (H⁺) was ion-implanted through the thermal oxide film and the enriched SiGe layer under the condition that the implantation energy was 20 keV and the dose amount was 5×10¹⁶ atoms/cm², and thereby an ion implanted layer was formed inside the silicon single crystal wafer. After the hydrogen ion implantation, the surface of the thermal oxide film was cleaned with an SC-1 cleaning solution. This surface and a silicon single crystal base wafer were closely contacted at a room temperature, and delamination heat treatment was performed and thereby the delamination was performed at the ion implanted layer. Thereby, the SiGe layer and a part (Si layer) of the silicon single crystal wafer were transferred to a side of the base wafer. Next, the transferred Si layer was removed with a TMAH solution and thereby, the enriched SiGe layer was exposed. On its surface, a silicon layer was epitaxially grown only at a thickness of 15 nm by a CVD method.

A surface of a bonded wafer produced as described above was subject to Secco-etching and an observation of crystal defects was conducted. It was confirmed that there were a larger number of Secco defects than that of Example 1 and that misfit dislocations were generated. Moreover, it was found that the lattice relaxation rate of the enriched SiGe layer was approximately 50% and that the lattice relaxation rate was smaller than that of Example 1.

That is, in the semiconductor wafer produced according to the present invention, the number of generated voids and blisters was significantly small and also the number of Secco defects was significantly small, and thereby the effect of the present invention was confirmed.

The present invention is not limited to the above-described embodiments. The above-described embodiments are mere examples, and those having the substantially same constitution as that described in the appended claims and providing the similar action and advantages are included in the scope of the present invention.

## Claims

1. A method for producing a semiconductor wafer, comprising at least steps of:
epitaxially growing a SiGe layer on a surface of a silicon single crystal wafer that is to be a bond wafer;
implanting at least one kind of hydrogen ion and rare gas ion through the SiGe layer, so that an ion implanted layer is formed inside the bond wafer;
closely contacting and bonding a surface of the SiGe layer and a surface of a base wafer through an insulator film; then
performing delamination at the ion implanted layer;
removing a Si layer in a delaminated layer transferred to a side of the base wafer by the delamination, so that the SiGe layer is exposed; and then
subjecting the exposed SiGe layer to a heat treatment for enriching Ge under an oxidizing atmosphere and/or a heat treatment for relaxing lattice strain under a non-oxidizing atmosphere.

2. A method for producing a semiconductor wafer, comprising at least steps of:
epitaxially growing a plurality of SiGe layers through a Si layer, on a surface of a silicon single crystal wafer that is to be a bond wafer;
implanting at least one kind of hydrogen ion and rare gas ion through the plurality of SiGe layers, so that an ion implanted layer is formed inside the bond wafer;
closely contacting and bonding a surface of the SiGe layer that is an uppermost layer of the plurality of SiGe layers and a surface of a base wafer, through an insulator film; then
performing delamination at the ion implanted layer;
removing the Si layer and the SiGe layer, in a delaminated layer transferred to a side of the base wafer by the delamination, so that the SiGe layer that is the uppermost layer is exposed; and then
subjecting the exposed SiGe layer to a heat treatment for enriching Ge by thermal oxidation under an oxidizing atmosphere and/or a heat treatment for relaxing lattice strain under a non-oxidizing atmosphere.

3. The method for producing a semiconductor wafer according to Claim 1 or 2, wherein after performing the heat treatment for enriching Ge and/or the heat treatment for relaxing lattice strain, a Si single crystal layer is epitaxially grown on a surface of the exposed SiGe layer.

4. The method for producing a semiconductor wafer according to any one of Claims 1 to 3, wherein after the delamination at the ion implanted layer, a heat treatment for enhancing strength of the bonding at a temperature of 800°C or less under a non-oxidizing atmosphere is performed.

5. The method for producing a semiconductor wafer according to any one of Claims 1 to 4, wherein the removal of the Si layer and/or the SiGe layer is performed by at least any one of, polishing, etching, and removal of an oxide film after thermal oxidation at a temperature of 800°C or less under an oxidizing atmosphere.

6. The method for producing a semiconductor wafer according to any one of Claims 1 to 5, wherein before performing the heat treatment for enriching Ge and/or the heat treatment for relaxing lattice strain, an oxide film is formed on a surface of the exposed SiGe layer.

7. The method for producing a semiconductor wafer according to any one of Claims 1 to 6, wherein a Ge composition in the SiGe layer is 20% or less.

8. The method for producing a semiconductor wafer according to any one of Claims 1 to 7, wherein the insulator film through which the surface of the SiGe layer and the surface of the base wafer are closely contacted is formed on the surface of the base wafer.

9. The method for producing a semiconductor wafer according to any one of Claims 1 to 8, wherein the insulator film through which the surface of the SiGe layer and the surface of the base wafer are closely contacted is formed at least on the surface of the SiGe layer at a thickness of 50 nm or less.

10. The method for producing a semiconductor wafer according to any one of Claims 1 to 9, wherein as the base wafer, a silicon single crystal wafer or an insulator wafer is used.

11. The method for producing a bonded wafer according to any one of Claims 1 to 10, wherein a temperature in the heat treatment for enriching Ge is 900°C or more.
